# EUROPEAN PATENT APPLICATION

(11) **EP 4 375 677 A1**
(43) Date of publication of application: **29.05.2024**
(21) Application number: 22209004.5
(22) Date of filing: 23.11.2022
(51) Int. Cl.: G01R 1/073, G01R 31/28

(54) **COMPACT TEST FIXTURE**

(71) Applicant: Mikrodust AB, 223 63 Lund (SE)
(72) Inventor: Iderup, Mats, 226 55 Lund (SE); Thernström, Ola, 234 35 Lomma (SE)
(74) Representative: Hansson Thyresson AB

(57) **Abstract**

There is provided a test fixture (300) for testing of a device (100) with electronic junctions (101), the test fixture comprising: a routing board (303); at least one electronic instrument (301) for performing a test procedure of the device; a plurality of probes (302) arranged to provide a respective plurality of first electrical connections between the electronic junctions of the device and the routing board; and a backplane assembly (304) electrically connected to the instrument, wherein the backplane assembly is arranged to provide a second electrical connection to the routing board such that a test signal can be transmitted between the instrument and a selected set of electronic junctions of the device via the first and second connections.

## Description

### TECHNICAL FIELD

The present invention relates to a test fixture for testing of electronic devices, and more particularly to a compact test fixture for testing of devices with electronic junctions.

### BACKGROUND

Electronic devices often need to be tested during manufacturing to ensure proper and expected functioning of the electronic devices. This is particularly true if the electronic device is a complex electronic device comprising a vast number of electronic components. For example, the electronic device may comprise a large number of active components including integrated circuits, microprocessors, transistors or the like, and/or a large plurality of passive components such as resistors, capacitors and/or inductors.

One way of testing such electronic devices have been for a user and/or operator at the manufacturing facility to manually test the devices. However, this is very time and labor consuming. Furthermore, the tests have been performed using large generic instruments with a very large number of test and measurement functions, even though only a small number of these functions are used during a normal testing procedure.

It has therefore been proposed to use a test fixture for performing the test procedure using instruments that have been specifically designed for such tests. However, known test fixtures and associated testing methods have several drawbacks. For example, known test fixtures may be large and/or difficult to manufacture.

From the above, it is understood that there is room for improvements and the invention aims to solve or at least mitigate the above and other problems.

### SUMMARY

The invention is defined by the appended independent claims. Additional features and advantages of the concepts disclosed herein are set forth in the description which follows, and in part will be clear from the description, or may be learned by practice of the described technologies. The features and advantages of the concepts may be realized and obtained by means of the instruments and combinations particularly pointed out in the appended claims. These and other features of the described technologies will become more fully apparent from the following description and appended claims, or may be learned by the practice of the disclosed concepts as set forth herein.

An objective of the invention is to provide a test fixture with standardized components. Another objective of the invention is to decouple customer or purpose specific features from standardized features. Yet another objective of the invention is to provide a test fixture with a small form factor.

According to a first aspect, there is proved a test fixture for testing of a device with electronic junctions, the test fixture comprising: a routing board; at least one electronic instrument for performing a test procedure of the device; a plurality of probes arranged to provide a respective plurality of first electrical connections between the electronic junctions of the device and the routing board; and a backplane assembly electrically connected to the instrument, wherein the backplane assembly is arranged to provide a second electrical connection to the routing board such that a test signal can be transmitted between the instrument and a selected set of electronic junctions of the device via the first and second connections. The electronic instrument may be configured to transmit and/or receive the test signal. The electronic instrument may additionally, or alternatively, be configured to perform a test procedure of the device. In embodiments, the test fixture comprises a plurality of electronic instruments. The electronic junctions of the device may be test points.

The test fixture is advantageous in that customer or device specific components have been decoupled from standardized or generic components. For example, the backplane assembly can be manufactured independently of specific devices to be tested (e.g. specific layouts of electronic junctions) and independently of specific customer desires or needs. Furthermore, the device or customer-specific routing board is of low complexity allowing it to be easily manufactured. The manufacturing time, and/or lead time, of the test fixture may accordingly be reduced.

Furthermore, the routing board and the backplane assembly has a reduced size compared to instrument boards of known test fixtures. Thus, the test fixture has a small form factor.

Preferably, the backplane assembly comprises a connection interface configured to provide the second electrical connection. The connection interface may be a connection device such as a pin connector or a mass interface connector.

Preferably, the backplane assembly comprises a backplane, wherein the electronic instrument is electrically connected to the backplane, wherein the backplane is configured to electrically connect the electronic instrument to the connection interface. The electronic instrument may be physically arranged on the backplane.

Preferably, the backplane comprises electrically conducting traces for providing the electrical connection between the instruments and the connection interface. Thus, the test fixture may require no, or only a minimal number of, wires and cables.

Preferably, the routing board comprises a plurality of probe-receiving points, wherein the plurality of probes is arranged to provide the first electrical connections between the electronic junctions and the probe-receiving points, wherein the routing board is configured to electrically connect the probe receiving points to the connection interface. Preferably, the routing board comprises electrically conducting traces for providing the electrical connection between the probe-receiving points and the connection interface.

Thus, the test fixture may require no, or only a minimal number of, wires and cables. Furthermore, the routing board may comprise substantially only a printed circuit board. The manufacturing complexity of the routing board can accordingly be reduced.

The test fixture may further comprise a probe guide for guiding the plurality of probes to the respective plurality of probe-receiving points. The test fixture may further comprise a probe plate, and wherein the probe plate is provided with the probes. The test fixture may further comprise a support plate configured to support the device.

Preferably, the test fixture is configured to test a plurality of devices simultaneously. For example, the probes may include a plurality of sets of probes wherein each set of probes is a set of probes for testing of one electronic device.

Preferably, the probes are arranged in a predetermined cluster. Thus, the routing board (and/or the probe plate, and/or the support plate, and/or the probe guide) may be standardized. The test fixture can thus be manufactured in advance, and/or independently of specific devices to be tested and independently of specific customer desires or needs.

According to a second aspect, there is provided a method of testing a device with a plurality of electronic junctions, the method comprising: connecting a plurality of probes between a routing board and the electronic junctions of the device to form a respective plurality of first electrical connections; connecting an electronic instrument to a backplane assembly; connecting the backplane assembly to the routing board to form a second electrical connection; and transmitting a test signal from the electronic instrument to the electronic junctions via the first and second electrical connections.

According to a third aspect, there is provided a test fixture for testing of a device with electronic junctions, the test fixture comprising: a routing board; a plurality of probes arranged at predetermined positions, wherein the plurality of probes is arranged to provide a respective plurality of electrical connections between the electronic junctions of the device and the routing board; and at least one electronic instrument for performing a test procedure of the device, wherein the electronic instrument is configured to be electrically connected to the routing board such that a test signal can be transmitted between the instrument and a selected set of electronic junctions of the device via the first and second connections.

The test fixture is advantageous in that components (e.g. routing board (and/or the probe plate, and/or the support plate, and/or the probe guide) of the test fixture may be standardized. The test fixture can thus be manufactured in advance, and/or independently of specific devices to be tested and independently of specific customer desires or needs.

Preferably, the probes are arranged in a predetermined cluster.

According to a fourth aspect, there is provided a method of testing a device with electronic junctions, the method comprising: determining positions of a plurality of probes; arranging the electronic junctions of the device in dependence on the determined positions of the plurality of probes; providing a test fixture, wherein the plurality of probes is arranged according to the determined positions; connecting the plurality of probes between a routing board of the test fixture and the electronic junctions of the device so as to form a respective plurality of electrical connections; connecting an electronic instrument to the routing board; and transmitting a test signal from the electronic instrument to the electronic junctions.

### BRIEF DESCRIPTION OF THE DRAWINGS

In order to best describe the manner in which the above-described embodiments are implemented, as well as define other advantages and features of the disclosure, a more particular description is provided below and is illustrated in the appended drawings. Understanding that these drawings depict only exemplary embodiments of the invention and are not therefore to be considered to be limiting in scope, the examples will be described and explained with additional specificity and detail through the use of the accompanying drawings in which:
- Fig. 1: shows a schematic view of an electronic device;
- Fig. 2: shows schematic views of a known test fixture;
- Fig. 3: shows schematically an exploded view of a test fixture according to embodiments;
- Fig. 4: shows schematically a side view of a test fixture according to embodiments;
- Fig. 5: shows schematically a side view of a test fixture according to embodiments;
- Fig. 6: shows a method of testing an electronic device according to embodiments;
- Fig. 7: shows a routing board according to embodiments;
- Fig. 8: shows a method of testing an electronic device according to embodiments.

Further, in the figures like reference characters designate like or corresponding elements or parts throughout the several figures. The first digit in the reference character denotes the first figure in which the corresponding element or part appears.

### DETAILED DESCRIPTION

Various embodiments of the disclosed methods and arrangements are discussed in detail below. While specific implementations are discussed, it should be understood that this is done for illustration purposes only. A person skilled in the relevant art will recognize that other components, configurations, and steps may be used without parting from the spirit and scope of the claimed invention.

Hereinafter, certain embodiments will be described more fully with reference to the accompanying drawings. It will be apparent to those skilled in the art that various modifications and variations can be made without departing from the inventive concept. Other embodiments will be apparent to those skilled in the art from consideration of the specification and practice disclosed herein. It is to be understood that elements and materials may be substituted for those illustrated and described herein, parts and processes may be reversed or omitted, certain features may be utilized independently, and embodiments or features of embodiments may be combined, all as would be apparent to the skilled person in the art.

The embodiments herein are provided by way of example so that this disclosure will be thorough and complete, and will fully convey the scope of the inventive concept, and that the claims be construed as encompassing all modifications, equivalents and alternatives of the present inventive concept which are apparent to those skilled in the art to which the inventive concept pertains. If nothing else is stated, different embodiments may be combined with each other.

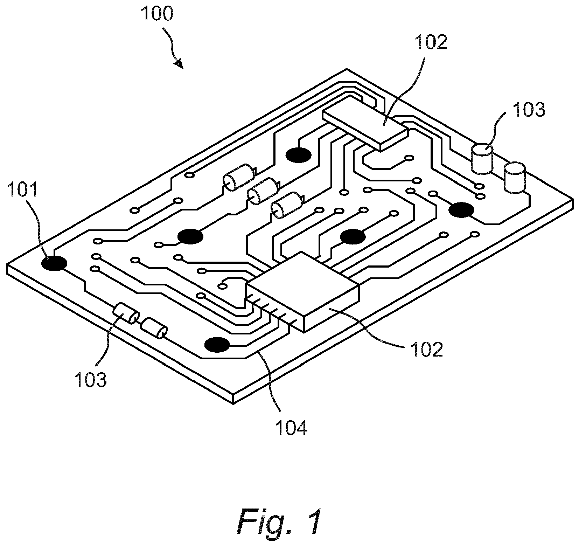

Fig. 1 shows an electronic device 100. The electronic device 100 may be a complex electronic device. The electronic device 100 may also be referred to as a device to be tested and/or a device under test (DUT).

The electronic device 100 may comprise one or more active electronic components 102, such as integrated circuits (ICs), microprocessors, microcontrollers, microchips, semiconductors, transistors, rectifiers, diodes, or the like. The electronic device 100 may comprise one or more passive electronic components 103, such as resistors, capacitors, inductors, transformers, or the like. Notably, the electronic device 100 may comprise a very large number of electronic components.

Furthermore, the electronic device 100 may comprise one or more components based on radio frequency (RF) communication. For example, the radio frequency components may be configured to communicate via a Blueetooth protocol, a WiFi protocol, a Zigbee protocol, or any other protocol for radio frequency-based communication.

The electronic device 100 may comprise a printed circuit board (PCB), or other board comprising electrically conducting traces 104 for connecting electronic components of the electronic device 100. The electronic device 100 may alternatively, or additionally, comprise wiring means (e.g. wires, cables, or the like) for connecting electronic components of the electronic device 100.

Due to the large number of electronic components of the electronic device 100, it is often necessary to test the electronic device 100 to ensure proper functioning of the electronic device 100. For this purpose, there may be provided one or more electronic junctions 101 in or on the electronic device 100 to which a test apparatus may be electrically connected so as to measure one or more parameters and/or test one or more functions of the electronic device 100. For example, an ampere meter and/or a voltage meter may be used to respectively measure the current and/or the voltage at an electronic junction 101 of the electronic device 100. The electronic junctions 101 may comprise test points, contact points, terminals of an electronic component, junctions, connections, and/or intersections in an electrical circuit, or the like.

Although Fig. 1 shows a specific electronic device 100, it will be appreciated that the shown electronic device 100 is for purely illustrative purposes, and that embodiments include apparatuses and methods for testing of any electronic device(s).

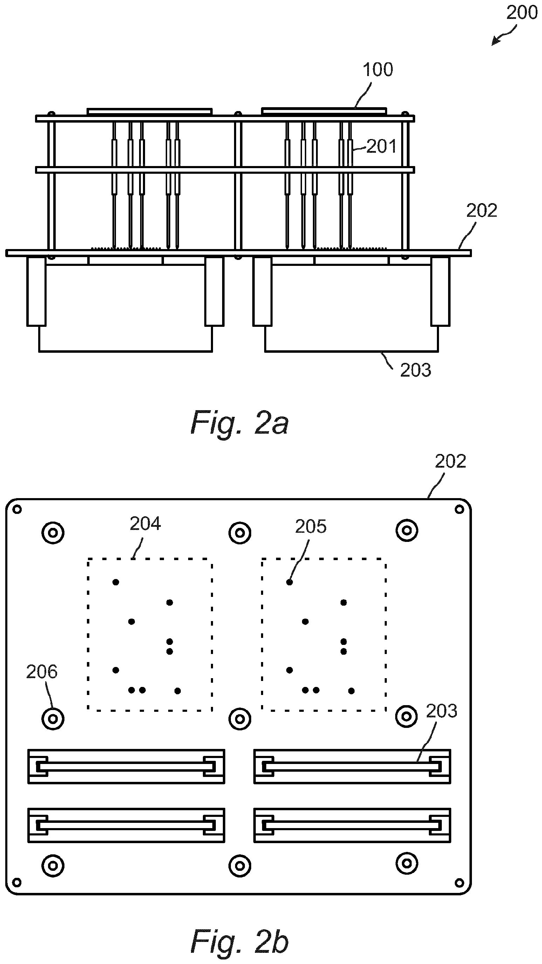

Fig. 2 shows schematically a known test fixture 200 for testing of electronic devices 100. Fig. 2a shows the test fixture 200 in an exploded side view. Fig. 2b shows a bottom view of an instrument board 202 of the test fixture 200. The test fixture 200 is configured to perform testing of two electronic devices 100.

As shown in Fig. 2b, the test fixture 200 comprises a plurality of probes 201 that are arranged between the electronic devices 100 and the instrument board 202. The probes 201 electrically connect points on the instrument board 202 to electronic junctions 101 of the electronic devices 100. The instrument board 202 is provided with electronic instruments 203 configured to perform a test procedure. The electronic instruments 203 are physically located on the instrument board 202. The instrument board 202 provides electrical connection (e.g. comprises electrically conducting traces; not shown) between the electronic instruments 203 and the points on the instrument board 202 that contacts the probes 201. An electrical connection between the electronic instruments 203 and the electronic devices 100 can thus be created. This allows the electronic instruments 203 to transmit test signals to, and/or receive test signals from, the electronic junctions 101 of the electronic devices 100. Hence, the electronic instruments 203 can test one or more parameters and/or functions of the electronic devices 100.

Fig. 2b shows the instrument board 202 in a plan view. The dashed rectangles 204 indicate the projected positions of the electronic devices 100, and the dots 205 indicate the points on the instrument board 202 where the probes 201 make contact. As can be seen, the area of the instrument board 202 needs to be significantly larger than the combined projected area 204 of the electronic devices 100. The instrument board area needs to accommodate all of: (i) the areas 204 of the projected electronic devices 100, (ii) the areas occupied by the electronic instruments 203 and associated attachment elements, (iii) electrically conducting traces (not shown) between the electronic instruments 203 and the points 205 on the instrument board 202 where the probes 201 make contact, (iv) a plurality of support elements 206 for maintaining a structural integrity of the test fixture 200 (note that the support elements 206 are not shown in Fig. 2a), and (v) one or more other components (not shown in Fig. 2a) that may be mounted on the instrument board 202, including sensors, antennas, indicators (such as diodes, LEDs, reverse-mounted LEDs, or the like), cut outs, or the like.

It should be noted that it is common for a known test fixture 200 to have a plurality of electronic instruments 203, in particular the test fixture 200 may commonly have 2, 4 or even 8 electronic instruments 203.

It should also be noted that the positions of the electronic junctions 101, and also the size and shape of the electronic devices 100, may vary depending on what electronic device 100 is to be tested.

Furthermore, it should be noted that the attachment elements of the electronic instruments 203 need to be carefully placed to avoid that the attachment elements interfere with support elements 206 and/or one or more other components that may be mounted on the instrument board 202, including sensors, antennas, indicators (such as diodes, LEDs, or the like), cut outs, or the like.

Moreover, it is often preferable to mount or attach the instruments 203 using through-holes in the instrument board 202, because such attachment increases the structural stability of the electronic instruments 203. In such a case, it is noted that the attachment elements of the electronic instruments 203 need to be positioned so as not to overlap with the dots 205 where the probes 201 make contact with the instrument board 202.

Hence, the inventors have realized that known test fixtures have several drawbacks. The inventors have realized that known test fixtures require an instrument board 202 with a large area to house all of the necessary components. The inventors have also realized that known test fixtures require many customer-specific components that need to be designed specifically for the needs of each customer. Furthermore, off-the-shelf housings for test fixtures commonly have an opening in a bottom surface thereof for accessing the electronic instruments. However, this opening typically overlaps with a section of the instrument board 202 where the slots for the electronic devices 101 are located.

Test fixtures according to embodiments overcome, or mitigate, one or more of these problems.

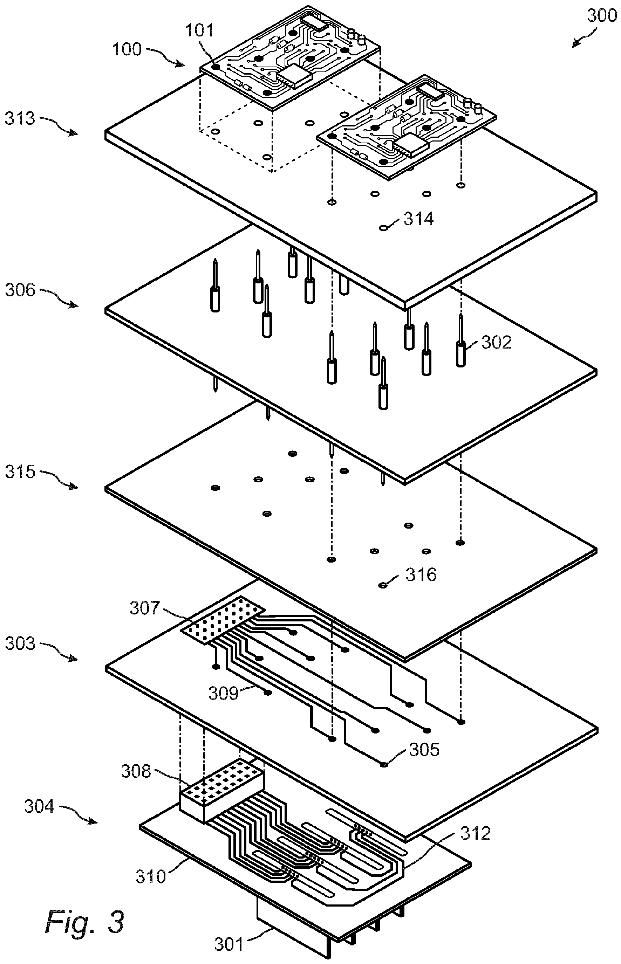

Embodiments, as shown in Figs. 3 to 8, provide a test fixture 300 with a small form factor. This allows the test fixture 300 to fit into a smaller housing, which allows off-the-shelf housings to be used. The compact test fixture 300 is also advantageous in that it takes up little space at the testing facility and can easily be placed on an existing worktop or workbench.

Embodiments provide a test fixture 300 where customer or purpose specific features are decoupled from standardized features. In other words, there is provided a test fixture 300 where standardized components have been separated from customer or purpose specific components. Thus, only a portion of the components of the test fixture 300 needs to be designed and manufactured in accordance with the specific needs and/or desires of a customer. The remaining components may be manufactured separately and may also be manufactured in advance so as to reduce the lead time of such components. Hence, the manufacturing cost and manufacturing time of a test fixture 300 can be greatly reduced.

Embodiments provide a test fixture 300 with minimal amount of cabling between components of the test fixture 300. The minimal amount of cabling reduces the number of components of the test fixture 300, and, in particular, reduces the number of non-integral components of the test fixture 300. Furthermore, the risk of human errors when assembling the test fixture 300 is significantly reduced. It is also significantly easier to repair (e.g. by finding and replacing a faulty feature) a test fixture 300 with minimal cabling.

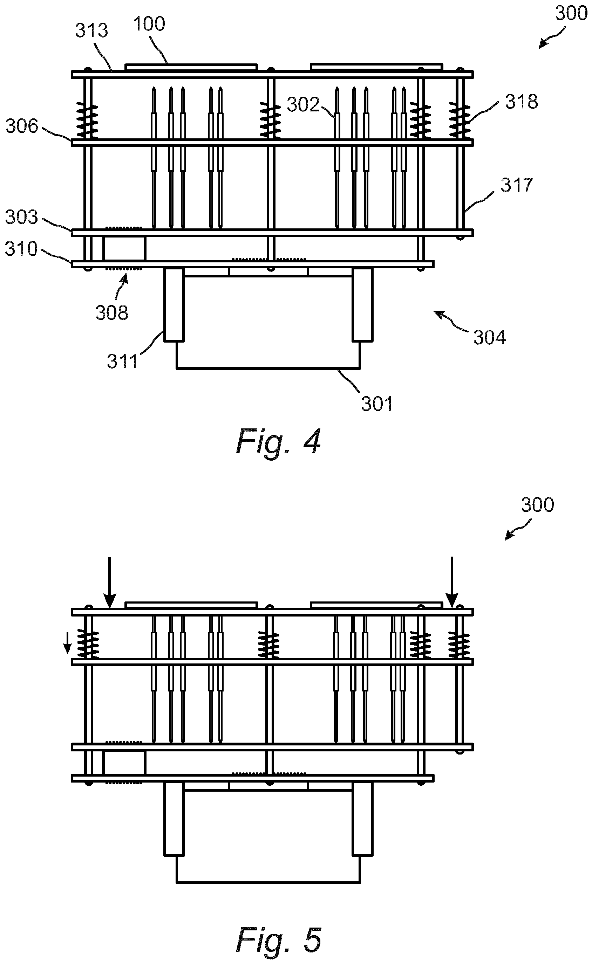

Figs. 3 and 4 show simplified schematic views of a test fixture 300 according to embodiments. Fig. 3 shows an exploded view of a test fixture 300. Fig. 4 shows a side view of the test fixture 300.

The test fixture 300 comprises at least one electronic instrument, a plurality of probes 302, a routing board 303, and a backplane assembly 304.

The test fixture 300 is configured to perform a test procedure of one or more electronic devices 100. The test procedure may comprise testing, controlling, measuring, and/or evaluating, of the electronic device 100 in accordance with a test specification or test protocol. The test specification or protocol may include testing, controlling, measuring, and/or evaluating of one or more components or parameters of the electronic device 100. The test specification or protocol may additionally, or alternatively, include testing, controlling, measuring, and/or evaluating of one or more functions of the electronic device 100.

The test fixture 300 comprises one or more electronic instruments 301 configured to perform the test procedure of the electronic device 100. Although Fig. 3 shows four electronic instruments 301, the test fixture 300 may comprise one, two, three, four, six, eight, or more electronic instruments 301.

As part of the test procedure, the electronic instruments 301 may be configured to transmit electrical testing signals to the electronic device 100, and/or receive electrical testing signals from the electronic device 100.

The electronic instruments 301 may include instruments for performing one or more measurement at electronic junctions 101 of the electronic devices 100. The measurements may include voltage measurements, current measurements, frequency measurements, or the like. The electronic instruments 301 may additionally, or alternatively, include instruments for generating and transmitting electrical signals. Thus, the electrical instruments may comprise a voltage supply and/or a current supply. For example, one or more of the instruments may be configured to apply a voltage to one electrical junction of the electronic device 100, and in turn measure a current at another electrical junction of the electronic device 100 (or vice versa).

The electrical signals may comprise signals of different waveforms. The different waveforms may include sinusoidal waveforms, square (or rectangular) waveforms, triangular waveforms, impulse-based waveforms, or any other waveform suitable for performing a test procedure. The waveforms may alternatively, or additionally, be tuned to a predetermined amplitude, a predetermined frequency, a predetermined phase, or the like.

The electronic instruments 301 may additionally, or alternatively, include instruments for performing test procedures based on boundary scan testing, digital and/or analogue input and/or output (i.e. digital and/or analogue I/O), image acquisition, or any other testing procedure suitable for testing of the electronic device 100.

The electronic instruments 301 may additionally, or alternatively, include one or more instruments for programming and/or debugging one or more components of the electronic device 100.

The electronic instruments 301 may additionally, or alternatively, include one or more instruments for performing radio frequency (RF) based measurements of the electronic devices 100, such as an RF frequency measurement and/or an RF power measurement. To this effect, the electronic instruments 301 may comprise a radio frequency generator.

The electronic instruments 301 may include one or more base instruments for controlling one or more of the other electronic instruments 301. The base instrument may be connected to a computer or other controller of the test fixture 300.

The electronic instruments 301 are electrically connected to the backplane assembly 304. Preferably, the electronic instruments 301 are attached to, or otherwise physically provided on, the backplane assembly 304. For example, the electronic instruments 301 may be connected to the backplane assembly 304 by a standard PCI express connector or a standard 37 pin D-sub connector.

The test fixture 300 is arranged to provide electrical connection between the electronic instruments 301 and electronic junctions 101 of the electronic device 100. The electrical connection between the electronic device 100 and the electronic instruments 301 is provided by the probes 302, the routing board 303 and the backplane assembly 304.

The probes 302 are arranged to provide electrical connection between electronic junctions 101 of the electronic device 100 and the routing board 303.

A first end or terminal of each probe 302 is arranged to make contact with (or impinge on) an electronic junction 101 of the electronic device 100. A second end or terminal of each probe 302 is arranged to make contact with (or impinge on) the routing board 303. The point on the routing board 303 where a probe 302 impinges, may be referred to as a probe-receiving point 305 of the routing board 303. Thus, each probe 302 of the plurality of probes 302 is configured to provide an electrical connection between respective electronic junctions 101 of the electronic device 100 and respective probe-receiving points 305 of the routing board 303.

The probes 302 may be any suitable connector for providing electrical connection between the junctions of the electronic device 100 and the probe-receiving points 305 of the routing board 303. For example the probes 302 may have a needle-like shape. The probes 302 may be at least partially rigid (e.g. substantially stiff in a bending and twisting fashion). Preferably, the probes 302 are spring-loaded (e.g. biased by a spring or other force-exerting member) in at least one end such that a length of the probe 302 can be adjusted by applying a force along the longitudinal axis of the probe. The probes 302 are preferably spring-loaded in both ends.

The probes 302 may have any suitable tip shape, including a tapered tip, a flat tip, a rounded tip, a tip provided with teeth or other protrusions. The tip shapes of the probes 302 may differ between first and second end of the probes 302. The tip shapes of the probes 302 may additionally, or alternatively, differ between probe 302 and probe 302. The tip shape and/or tip size may be chosen in dependence on the electronic device 100 to be tested.

The probes 302 may be attached to, or held by, a probe plate 306. The probes 302 are preferably attached to the probe plate 306 at a central portion of the probes 302, such that the probes 302 extend through the probe plate 306. This allows a first portion of the probes 302 to extend from the probe plate 306 in a one direction (e.g. towards the electronic device 100), and a second portion of the probes 302 to extend from the probe plate 306 in an opposite direction (e.g. towards the routing board 303). In embodiments, each probe 302 may comprise two parts that are electrically connected to each other. For example, a first part may be placed on one side of the probe plate 306 and a second part may be placed on the other side of the probe plate 306.

The probes 302 are preferably spring-loaded on both sides of the probe plate 306. That is, a length of both the first portion (extending towards the electronic device 100) and the second portion (extending towards the routing board 303) of the probes 302 may be adjusted by applying a force along the longitudinal axis of the probe. A stable connection between the electronic junctions 101 and the probe-receiving points 305 on the routing board 303 can thus be established.

The routing board 303 is arranged to provide electrical connection between the probe-receiving points 305 of the routing board 303 and interface-connecting points 307 on the routing board 303. The interface-connecting points 307 are points on the routing board 303 that are arranged to be connected to a connection interface 308 of the backplane assembly 304.

The routing board 303 may be a substantially flat plate. The size (e.g. width and length) and shape of the routing board 303 may be determined in dependence on the number and/or size of the electronic devices 100 to be tested (to have an area accommodating all probes 302). The size and shape of the routing board 303 may be additionally, or alternatively, be determined in dependence on the number and/or position of the electronic junctions 101 on the electronic device 100. Importantly, the size and shape of the routing board 303 may be determined independently of the size and number of electronic instruments 301. Thus, the size (e.g. width and length) of the routing board 303 can be significantly smaller than the size of the instrument board 202 because the routing board 303 does not need to accommodate the electronic instruments 301.

The routing board 303 may comprise electrical traces 309 for providing the electrical connection between the probe-receiving points 305 and the interface-connecting points 307. In other words, the routing board 303 may be configured to route electrical signals between the probe-receiving points 305 and the connection interface 308.

There may be provided one or more electrical traces 309 connecting each probe-receiving point 305 to one or more respective terminals of the connection interface 308 (note that for simplicity, only one such trace 309 is shown in Fig. 3). Preferably, the routing board 303 comprises a printed circuit board providing the electrical traces 309 between the probe-receiving points 305 and the connection interface 308.

The backplane assembly 304 is arranged to provide electrical connection between the interface-connecting points 307 of the routing board 303 and the electronic instruments 301.

The backplane assembly 304 comprises a connection interface 308 that provides an electrical connection between the backplane assembly 304 and the routing board 303. The connection assembly may comprise wiring means, such as wires or cables, and/or a connection device for providing the connection to the interface-connecting points 307 of the routing board 303. Preferably, the connection device is a pin connector such as a mass interface connector (as shown). For example, the connection device may comprise a plurality of pins, preferably at least 50 pins, more preferably at least 100 pins, and yet more preferably at least 150 pins. When using a connection device, the interface-connecting points 307 on the routing board 303 may be collected in a cluster-like manner corresponding to terminals of the connection device.

The backplane assembly 304 preferably comprises a backplane 310 to which the electronic instruments 301 are connected. Preferably, the electronic instruments 301 are physically arranged on the backplane 310. For example, the electronic instruments 301 may be arranged in holders 311 attached to the backplane 310 as shown in Fig. 4.

Importantly, the backplane 310 is separate from the routing board 303, but electrically connected thereto through the connection interface 308.

The backplane 310 may be a substantially flat plate or board. The size (e.g. width and length) and shape of the backplane 310 may be determined in dependence on the number of electronic instruments 301 and/or the size of the electronic instruments 301. Importantly, the size and shape of the backplane 310 may be determined independently of the size and number of electronic devices 100 to be tested, and may also be determined independently of the positions of the electronic junctions 101 of the electronic devices 100. Thus, the backplane 310 may be designed independently of the electronic devices 100 to be tested. Hence, the design of the backplane 310 may be standardized, and used for testing of any electronic device 100. In other words, the backplane 310, and in turn the backplane assembly 304, is not customer specific.

Furthermore, the size (e.g. width and length) of the backplane 310 can be significantly smaller than the size of the instrument board 202 because the backplane 310 does not need a designated area for receiving the probes 302.

The backplane 310 may be configured to electrically connect the electronic instrument 301 to the connection interface 308. Preferably, the backplane 310 comprises conducting traces 312 for providing said connection. For example, the backplane 310 may comprise a printed circuit board that provides the traces 312 between the electronic instruments 301 and the connection interface 308.

Preferably, two or more electronic instruments 301 may be interchangeably placed in the associated instrument slots in the backplane assembly 304. For example, the base instrument may have a designated instrument slot, while two or more (and preferably all) of the other electronic instruments 301 may be interchangeably placed in the remaining instrument slots (as shown in Fig. 3). To this effect, the backplane assembly 304 and/or the backplane 310 may comprise electrical connections (e.g. electrically conducting traces) allowing the interchangeable connection of electronic instruments 301. In embodiments, all electronic instruments 301 may be interchangeably placed in the instrument slots.

The backplane assembly 304 may further comprise various standard components (not shown) that may be beneficial for operation of the test fixture 300, including a power supply and/or power connection means for connection to a power source, a communication unit for communication with a remote system (e.g. computer, server, another test fixture 300, or the like), and/or a connection to a controller for controlling the test fixture 300 and/or the electronic instruments 301. The connection interface 308 may hence, where necessary, include connections (e.g. pins) for connection of these components to the routing board 303 and/or the electronic devices 100.

Thus, the routing board 303 may be kept free from standard components. This allows the routing board 303 to comprise substantially only the electrical connections between the probe-receiving points 305 and the interface-connecting points 307 (e.g. the routing board 303 may be substantially only a printed circuit board). The routing board 303 is thus quick and cheap to design and manufacture, allowing for short lead times.

Hence, the customer specific features of the test fixture 300 are decoupled from the standard or generic features of the test fixture 300. The backplane assembly 304, which comprises only standard or generic features, may be manufactured in advance and independent of specific customer needs and/or specific electronic devices 100. The routing board 303 on the other hand, which comprises the customer-specific features, has a low complexity and only a small number of components.

Furthermore, the test fixture 300 ensures that the placement of electronic instruments 301 does not interfere with the placement of one or more other components such as sensors, antennas, indicators (such as diodes, LEDs, or the like), cut outs, or the like.

The test fixture 300 is also particularly advantageous for testing of electronic devices 100 comprising one or more radio frequency (RF) based components, because the electronic components placed in or on the backplane assembly 304, as opposed to on the routing board, can easily be shielded or isolated from the electronic device 100 during testing, without having to move any of the electronic components independently.

The test fixture 300 may further comprise a support plate 313 for holding the electronic device(s) 100. The support plate 313 may be located between the electronic devices 100 and the probes 302 and/or probe plate 306. The support plate 313 may be a substantially flat plate or board. The support plate 313 may comprise through-apertures 314 in positions corresponding to the electronic junctions 101 of the electronic device 100, so as to allow the probes 302 to pass therethrough in order to contact the electronic junctions 101. The support plate 313 may comprise one or more holding elements (not shown) arranged to ensure that the electronic devices 100 are kept still in the desired positions (i.e. with the electronic junctions 101 aligned with the probes 302).

The support plate 313 may comprise one slot for one electronic device 100 to be tested. The support plate 313 may alternatively comprise a plurality of slots for a respective plurality of electronic devices 100 to be tested. For example, the support plate 313 may have slots for testing of e.g. 2, 3, 4, or more electronic devices 100 simultaneously.

The test fixture 300 may further comprise a probe guide 315. The probe guide 315 may be arranged between the routing board 303 and the probes 302 and/or probe plate 306. Because the probes 302 may not be fully rigid (i.e. the probes 302 may experience some flexibility, especially if they are very slender), the probe guide 315 may be arranged to ensure that the probes 302 are aligned so as to make contact with the routing board 303 at the correct positions and/or to ensure that the probes 302 are sufficiently separated from one another so as to avoid electrical shorting. The probe guide 315 may be a substantially flat plate or board. The probe guide 315 comprises through-apertures 316 in positions corresponding to the probes 302, so as to allow the probes 302 to pass therethrough, and to ensure that the probes 302 remain substantially aligned along their length. Note that the probe guide 315 is not shown in Fig. 4.

The test fixture 300 may further comprise a plurality of support elements 317 for maintaining a structural integrity of the test fixture 300 (as shown in Fig. 4). The support elements 317 may collectively hold together the probe plate 306, the routing board 303, and the backplane assembly 304. Preferably, the support elements 317 collectively hold together the support plate 313, the probe plate 306, the probe guide 315, the routing board 303, and the backplane assembly 304.

The probe plate 306 may be mechanically fixed in relation to the routing board 303 by one or more of the support elements 317. Preferably, the probe guide 315 is mechanically fixed in relation to the routing board and/or the probe plate 306 by one or more of the support elements 317.

A distance between the support plate 313 and the probe plate 306 and/or the routing board 303 is preferably adjustable. For example, support elements 317 between the support plate 313 and the probe plate 306 may comprise one or more compression elements 318 (e.g. springs) so as to allow a distance between the pair of plates to be adjusted by a compression force. The compression elements 318 thus allow the probes 302 to make contact with the electronic device 100 when the support plate 313 is pressed towards the routing board 303. This can be seen in Fig. 5. Hence, a user may (electrically) connect the electronic devices 100 to the test fixture 300 when a pressing motion is performed on the support plate 313. This pressing motion may, for example, correspond to a lid of the test fixture 300 housing being in a closed state.

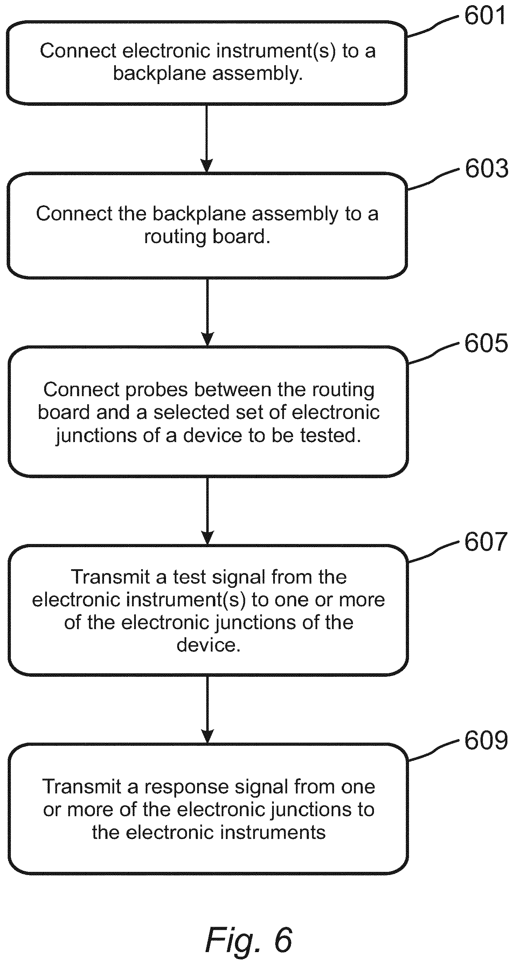

Fig. 6 shows a method of testing an electronic device 100 according to embodiments.

In step 601, one or more electronic instruments 301 are connected to the backplane assembly 304.

In step 603, the backplane assembly 304 is connected to the routing board 303 to form a first electrical connection. This may be permed via the connection interface 308.

In step 605, probes 302 are connected between the routing board 303 and a selected set of electronic junctions 101 of the electronic device 100. Thus, a plurality of second electrical connections is formed (one for each probe).

In step 607, a test signal is transmitted from one or more of the electronic instruments 301 to one or more of the electronic junctions 101 of the electronic device 100. The test signal is transmitted via the first and second electrical connections.

In step 609, a response signal is transmitted from one or more of the electronic junctions 101 of the electronic device 100 to one or more of the electronic instruments 301. The response signal is transmitted via the first and second electrical connections.

The method may further comprise a step of testing, verifying and/or determining if a component and/or function of the electronic device 100 is works correctly or in an expected way. The method may further comprise a step of approving the tested electronic device 100 in dependence on the component and/or function of the electronic device 100 working correctly or in an expected way (and/or disapproving the tested electronic device 100 if the component and/or function of the electronic device 100 is not working correctly or in an expected way).

The inventors have further realized that a test fixture 300 according to embodiments may comprise a standardized routing board 700. That is, a routing board 700 that may be manufactured in advance and/or not in dependence on specific needs of a customer or an electronic device 100 to be tested. The test fixture 300 may also comprise one or more probe plates 306, support plates 313 and/or probe guides 315 that are standardized in the same way. The standardized routing board 700 (and standardized probe plates 306, support plates 313 and/or probe guides 315) may be used in combination with the previously described test fixture 300, or with any other test fixture. For example, electronic instruments 301 may be mounted directly on the standardized routing board 700 (as seen in Fig. 2), allowing the standardized routing board 700 to replace the instrument board of the test fixture 200 .

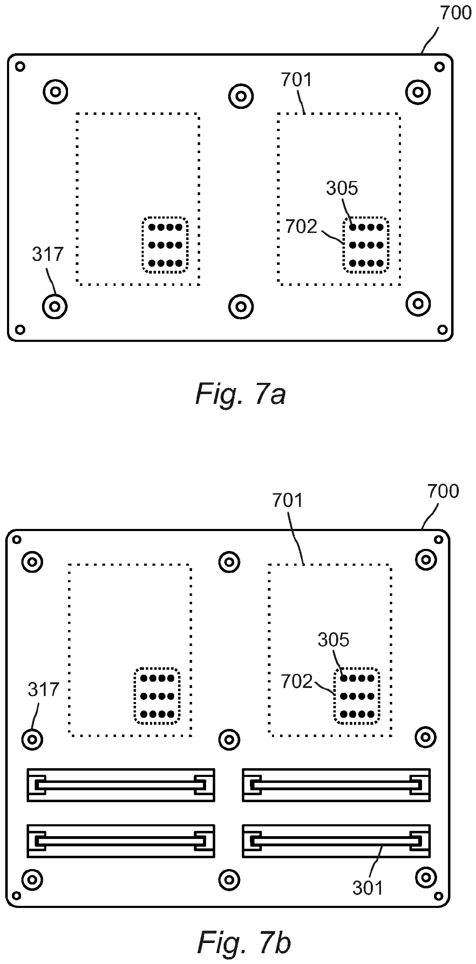

Fig. 7 shows exemplary standardized routing board 700 according to embodiments. Fig. 7a shows a standardized routing board 700 that can be used in combination with the embodiments in Figs. 3 and 4. Fig. 7b shows a standardized routing board 700 with the electronic instruments mounted directly on the standardized routing board such that it can be used in combination with a known test fixture 200 (as seen in Fig. 2). The dashed lines 701 indicate the projected areas of the electronic devices 100.

The standardized routing board 700 comprises probe-receiving points 305 in pre-determined positions. The predetermined probe positions are determined independently of specific customer needs and/or independently of the electronic device 100 to be tested. For example, the probe-receiving points 305 may be arranged in a predetermined pattern 702 such as a cluster as shown in Figs. 7a and 7b.

It follows that the probes will be arranged at positions corresponding to the pre-determined positions of probe-receiving points, for example at positions corresponding to the predetermined pattern 702, such as a cluster.

It will be appreciated that embodiments are not limited to the shown cluster, and rather includes any predetermined positions or pattern 702 of probe-receiving points.

The predetermination of positions of probe-receiving points 305 on the routing board 700 allows all components of the test fixture 300 to be manufactured in advance, and can accordingly significantly shorten lead times and significantly reduce manufacturing cost and complexity.

The electronic device 100 may then be designed in dependence on the predetermined probe positions of the routing board 700. That is, the electronic junctions 101 that are to be tested, may be arranged at positions corresponding to the probe-receiving positions of the routing board 700. In other words, the design process is somewhat reversed, with the electronic device 100 being designed in dependence on the test fixture 300, and not the other way around as is usually the case.

The manufacturers of electronic device 100 (that need to be tested) are often willing and able to adjust the design of the electronic device 100 (e.g. by moving one or more electronic junctions 101) if it results in them being able to start testing the electronic devices 100 more quickly (i.e. if a test fixture 300 can be manufactured and supplied to them more quickly).

Furthermore, because the probe-receiving points are located in pre-determined positions on the standardized routing board 700, the area occupied by the probe-receiving points is known in advance and will be the same irrespective of customer-specific needs and/or electronic devices 100. Thus, other components (such as the electronic instruments 301 in Fig. 7b) may be placed in areas overlapping with the projected area of the electronic devices 100 but not overlapping with the area occupied by the probe-receiving points (i.e. components may be placed inside the dashed line 701 but outside the dashed line 702. Accordingly, a size of the standardized routing board may be reduced.

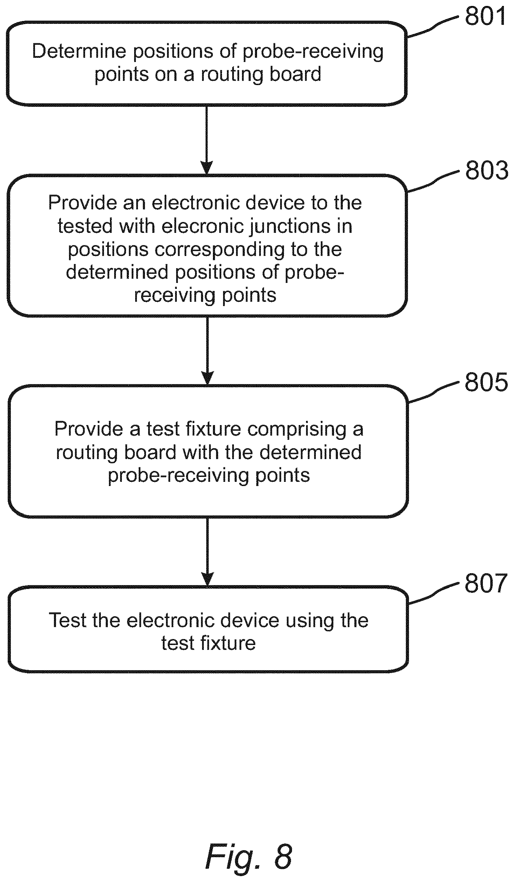

Fig. 8 shows a method of testing an electronic device 100 according to embodiments.

In step 801, the positions of probe-receiving points 305 are determined.

In step 803, there is provided an electronic device 100 with electronic junctions 101 in positions corresponding to the determined positions of probe-receiving points 305.

In step 805, there is provided a test fixture 300 comprising a routing board 700 with the determined probe-receiving points 305.

In step 807, the electronic device 100 is tested by the test fixture 300. The test may include the steps of: connecting the probes 302 between the routing board 700 and the electronic junctions 101 of the device 100, connecting an electronic instrument 301 to the routing board 700; and transmitting a test signal from the electronic instrument 301 to the electronic junctions 101. Alternatively, the test may be performed in accordance with the method of Fig. 6.

Throughout this specification, the word "may" is used in a permissive sense (i.e. meaning having the potential to), rather than in the mandatory sense (i.e. meaning must).

Throughout this specification, the words "comprise", "include", and variations of the words, such as "comprising" and "comprises", "including", "includes", do not exclude other elements or steps.

As used throughout this specification, the singular forms "a", "an", and "the", include plural referents unless explicitly indicated otherwise. Thus, for example, reference to "an" element includes a combination of two or more elements, notwithstanding use of other terms and phrases for one or more elements, such as "one or more" or "at least one".

The term "or" is, unless indicated otherwise, non-exclusive, i.e. encompassing both "and" and "or". For example, the feature "A or B" includes feature "A", feature "B" and feature "A and B".

Unless otherwise indicated, statements that one value or action is "based on" and/or "in dependence on" another condition or value or action, encompass both instances in which the condition or value or action is the sole factor and instances where the condition or value or action is one factor among a plurality of factors.

Unless otherwise indicated, statements that "each" instance of some collection have some property should not be read to exclude cases where some otherwise identical or similar members of a larger collection do not have the property, i.e. each does not necessarily mean each and every.

## Claims

1. A test fixture for testing of a device with electronic junctions, the test fixture comprising:
a routing board;
at least one electronic instrument;
a plurality of probes arranged to provide a respective plurality of first electrical connections between the electronic junctions of the device and the routing board; and
a backplane assembly electrically connected to the instrument, wherein the backplane assembly is arranged to provide a second electrical connection to the routing board such that a test signal can be transmitted between the instrument and a selected set of electronic junctions of the device via the first and second connections.

2. The test fixture according to claim 1, wherein the backplane assembly comprises a connection interface configured to provide the second electrical connection, wherein optionally, the connection interface is a connection device such as a pin connector or a mass interface connector.

3. The test fixture according to claim 2, wherein the backplane assembly comprises a backplane,
wherein the electronic instrument is electrically connected to the backplane,
wherein the backplane is configured to electrically connect the electronic instrument to the connection interface, and
wherein, optionally, the backplane comprises electrically conducting traces for providing the electrical connection between the instruments and the connection interface.

4. The test fixture according to claim 3, wherein the instrument is physically arranged on the backplane.

5. The test fixture according to any of claims 2 to 4, wherein the routing board comprises a plurality of probe-receiving points,
wherein the plurality of probes is arranged to provide the first electrical connections between the electronic junctions and the probe-receiving points,
wherein the routing board is configured to electrically connect the probe receiving points to the connection interface, and
wherein optionally the routing board comprises electrically conducting traces for providing the electrical connection between the probe-receiving points and the connection interface.

6. The test fixture according to claim 5, wherein the test fixture further comprises a probe guide for guiding the plurality of probes to the respective plurality of probe-receiving points.

7. The test fixture according to any preceding claim, wherein the electronic instrument is configured to transmit and/or receive the test signal.

8. The test fixture according to any preceding claim, wherein the test fixture further comprises a probe plate, and wherein the probe plate is provided with the probes.

9. The test fixture according to any preceding claim, wherein the test fixture further comprises a support plate configured to support the device.

10. The test fixture according to any preceding claim, wherein the test fixture is configured to test a plurality of devices simultaneously.

11. The test fixture according to any preceding claim, wherein the probes are arranged in a predetermined cluster.

12. A method of testing a device with a plurality of electronic junctions, the method comprising:
connecting a plurality of probes between a routing board and the electronic junctions of the device to form a respective plurality of first electrical connections;
connecting an electronic instrument to a backplane assembly;
connecting the backplane assembly to the routing board to form a second electrical connection; and
transmitting a test signal from the electronic instrument to the electronic junctions via the first and second electrical connections.

13. A test fixture for testing of a device with electronic junctions, the test fixture comprising:
a routing board;
a plurality of probes arranged at predetermined positions, wherein the plurality of probes is arranged to provide a respective plurality of electrical connections between the electronic junctions of the device and the routing board; and
at least one electronic instrument electrically connected to the routing board, such that a test signal can be transmitted between the instrument and a selected set of electronic junctions of the device via the first and second connections.

14. The test fixture according to claim 13, wherein the probes are arranged in a predetermined cluster.

15. A method of testing a device with electronic junctions, the method comprising:
determining positions of a plurality of probes;
arranging the electronic junctions of the device in dependence on the determined positions of the plurality of probes;
providing a test fixture, wherein the plurality of probes is arranged according to the determined positions;
connecting the plurality of probes between a routing board of the test fixture and the electronic junctions of the device so as to form a respective plurality of electrical connections;
connecting an electronic instrument to the routing board; and
transmitting a test signal from the electronic instrument to the electronic junctions.
